# EUROPÄISCHE PATENTSCHRIFT

(11) **EP 2 338 320 B1**
(45) Veröffentlichungstag und Bekanntmachung des Hinweises auf die Patenterteilung: **17.04.2013**
(21) Anmeldenummer: 09765003.0
(22) Anmeldetag: 09.10.2009
(51) Int. Cl.: H05K 3/00, H05K 1/11

(54) **SCHUTZABDECKUNG FÜR EINE FLEXIBLE LEITERPLATTE**
PROTECTIVE COVER FOR A FLEXIBLE PRINTED CIRCUIT BOARD
RECOUVREMENT PROTECTEUR POUR PLAQUETTE À CIRCUIT IMPRIMÉ SOUPLE

(30) Priorität: 18.10.2008 DE 102008052243
(43) Veröffentlichungstag der Anmeldung: 29.06.2011
(73) Patentinhaber: Conti Temic Microelectronic GmbH, 90411 Nürnberg (DE); Carl Freudenberg KG, 69469 Weinheim (DE); Swoboda KG, 87487 Wiggensbach (DE)
(72) Erfinder: SCHARRER, Klaus, 91224 Hohenstadt (DE); LIEBL, Tilo, 91219 Hersbruck (DE); WIECZOREK, Mathias, 91233 Neunkirchen am Sand (DE); WENK, Alexander, 91595 Burgoberbach (DE); HÄRING, Hans-Jürgen, 87448 Waltenhofen (DE); HENNIGER, Jürgen, 91056 Erlangen-Dechsendorf (DE); BAUMANN, Karl-Heinz, 68519 Viernheim (DE)
(86) Internationale Anmeldenummer: PCT/DE2009/001410
(87) Internationale Veröffentlichungsnummer: WO 2010/043204

(56) Entgegenhaltungen:
- DE-U1- 9 307 959
- DE-U1- 9 419 187
- DE-U1- 29 615 553
- US-A- 1 288 395
- US-A- 4 450 955
- US-A1- 2003 089 784

## Beschreibung

Die Erfindung betrifft eine Schutzabdeckung zur schützenden Halterung einer flexiblen Leiterplatte. Ferner betrifft die Erfindung eine Leiterplatte mit einer derartigen Schutzabdeckung.

Flexible Leiterplatten weisen eine flexible Folie aus isolierendem Material mit fest haftenden leitenden Verbindungen auf und dienen einer mechanischen Befestigung und elektrischen Verbindung elektronischer Bauteile. An Oberflächen der flexiblen Leiterplatten sind Kontaktflächen angebracht, wobei ein einwandfreier Zustand der Kontaktflächen für eine nachfolgende fehlerfreie Verwendung der flexiblen Leiterplatte Voraussetzung ist.

Eine Prozesskette zur Herstellung, Weiterverarbeitung und Montage einer flexiblen Leiterplatte umfasst eine Vielzahl an einzelnen Prozessschritten, die durch verschiedene Handhabungs- und/oder Transportschritte miteinander verknüpft sind. Insbesondere durch manuelle und/oder maschinelle Handhabungs- und/oder Transportschritte können Beschädigungen der Kontaktfläche durch Verkratzen und Verunreinigung der Kontaktfläche durch Handschweiß, Öl bzw. Fett und vorhandenen Partikeln auf einer Auflagefläche auftreten. Derartig beschädigte oder verunreinigte flexible Leiterplatten sind für eine weitere Verwendung nicht geeignet.

Zum Schutz von Kontaktflächen vor Beeinträchtigungen durch Verunreinigung oder Beschädigung werden Schutzauflcleber, die auf die Kontaktflächen aufgeklebt werden, vorgesehen. Bei einer Entfernung des Schutzaufklebers können Rückstände einer Klebeschicht auf der Kontaktfläche verbleiben, sodass eine Verunreinigung der Kontaktfläche resultiert. Weiterhin sind separate Schutzeinrichtungen zur Verwendung in einzelnen Fertigungsanlagen sowie aufwendige Handhabungsschritte in Form einer manuellen Handhabung mit Schutzhandschuhen oder zusätzlichen, aufwändig gestalteten Greifer-Systemen bei einer maschinellen Handhabung bekannt. Die genannten Schutzvorkehrungen sind anlagen- und/oder zeitaufwändig und deshalb kostenintensiv. Weiterhin besteht die Gefahr von Beschädigung und/oder Verunreinigung der Kontaktflächen nach Beendigung eines Prozessschrittes und anschließender Handhabung oder Transport der flexiblen Leiterplatten.

Die US 2003/0089784 A1 beschreit eine kartenähnliche Vorrichtung mit einer starren Leiterplatte, einen leitenden Rahmen zum Unterstützen der Leiterplatte, und eine leitende Verkleidung, angeordnet am leitenden Rahmen, die in Verbindung mit dem leitendem Rahmen die Leiterplatte umgibt.Der Rahmen weiterhin ausgestattet mit Eingriffbereichen, welche benachbart zu den entsprechenden ersten Kontaktbereichen im Rahmenbereich angeformt sind. Jeder Eingriffbereich umfasst eine Rippe , die entlang der inneren Umfangswand des Rahmenbereichs hervortritt und den Leiterplattenaufnahmebereich definiert. Jede Rippe erstreckt sich parallel zu den Oberflächen des Leiterplattenaufnahmebereiches, und ist gegenüber dem Vorsprung am Ende jeden Armes angeordnet. Zwischen dem Vorsprung und der Rippe ist eine Lücke ausgebildet, in die die Leiterplatte eingeführt werden kann.

Die DE 94 19 187 U1 beschreibt eine flache Kartenhülle für Scheckkarten, Telefonkarten und Chipkarten, deren Aufnahmeraum für eine der genannten Karten unten von einem Bodenteil, das an den Seitenlängsrändem in zwei Führungsstreifen übergeht, und oben von einer Oberseite begrenzt ist, wobei eine stirnseitige Einschuböffnung zum Einschieben einer Karte in den Aufnahmeraum vorgesehen ist, und wobei das Bodenteil mindestens eine in Hüllenlängsrichtung verlaufende Vertiefung aufweist, die in einem Bereich angeordnet ist, in dem sich bei eingeschobener Karte der Magnetstreifen befindet.

Die US 1,288,395 beschreibt eine Visitenkartenschutzhülle, wobei die Visitenkarte durch eine Öffnung an einem Ende der Hülle eingeschoben werden kann.

Die US 4,450,955 beschreibt eine Schutzabdeckung für kartenförmige Datenträger mit einer Schutzeinheit und einer Aufnahmeeinheit, wobei die Schutzeinheit rahmenförmig ausgebildet ist, und wobei die Schutzeinheit eine rechteckige Grundplatte mit zwei gegenüberliegend angeordneten Entnahmeöffnungen aufweist.

All diesen Dokumenten ist gemein, dass der zu schützende Gegenstand in die Schutzabdeckung eingeführt bzw. eingeschoben wird, was die Gefahr birgt, dass dabei dessen Oberfläche beschädigt wird.

Es ist die Aufgabe der vorliegenden Erfindung, eine Schutzabdeckung zur schützenden Halterung einer flexiblen Leiterplatte derart zu schaffen, dass eine Oberfläche der flexiblen Leiterplatte entlang einer gesamten Prozesskette von einer Herstellung bis zu einer Montage der flexiblen Leiterplatte kostengünstig und zuverlässig vor Beschädigung und/oder Verunreinigung geschützt ist.

Diese Aufgabe ist erfindungsgemäß durch eine Schutzabdeckung mit den im Anspruch 1 angegebenen Merkmalen gelöst.

Erfindungsgemäß wurde erkannt, dass ein umfassender Schutz einer Oberfläche einer flexiblen Leiterplatte durch eine Schutzabdeckung erfolgt, wobei eine Schutz-Einheit der Schutzabdeckung die Oberfläche schützend abdeckt und eine Aufnahme-Einheit einer sicheren Aufnahme der flexiblen Leiterplatte in der Schutzabdeckung dient. Eine derartige Schutzabdeckung ist kostengünstig.

Eine Schutzabdeckung nach Anspruch 2 kann von einer flexiblen Leiterplatte einfach entfernt werden.

Eine Schutzabdeckung nach Anspruch 3 garantiert eine sichere Aufnahme einer flexiblen Leiterplatte.

Eine Schutzabdeckung nach Anspruch 4 garantiert eine sichere Halterung einer flexiblen Leiterplatte in der Schutzabdeckung.

Eine Schutzabdeckung nach Anspruch 5 ist kostengünstig herstellbar.

Eine Schutzabdeckung nach Anspruch 6 ermöglicht eine definierte und sichere Ablage einer flexiblen Leiterplatte.

Eine Schutzabdeckung nach Anspruch 7 dient einer sicheren Aufnahme einer flexiblen Leiterplatte.

Die Vorteile einer Leiterplatte nach Anspruch 8 entsprechen denen der unter den vorgenannten Ansprüchen erläuterten Vorteilen. Ausführungsbeispiele der Erfindung werden nachfolgend anhand der Zeichnung näher erläutert. In dieser zeigen:
- Fig. 1: eine Seitenansicht eines ersten Ausführungsbeispiels einer Schutzabdeckung mit Rastvorsprüngen und einer rastend aufgenommenen flexiblen Leiterplatte;
- Fig. 2: eine Draufsicht der in Figur 1 dargestellten Schutzabdeckung ohne Darstellung der flexiblen Leiterplatte;
- Fig. 3: eine Ansicht von unten der in Figur 1 dargestellten Schutzabdeckung mit flexibler Leiterplatte;

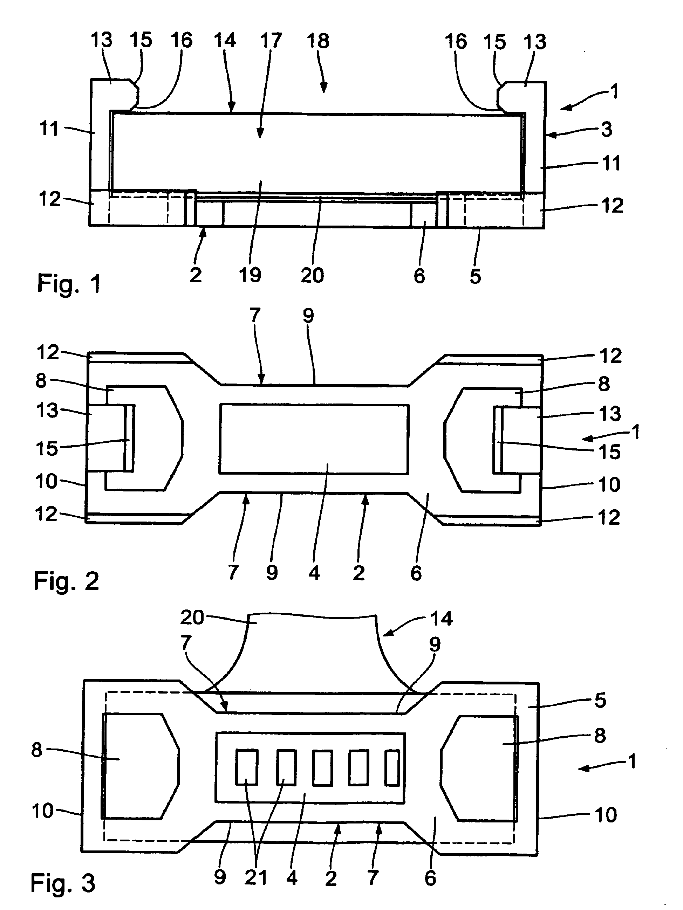

Ein in den Figuren 1 bis 3 dargestelltes erstes Ausführungsbeispiel einer Schutzabdeckung 1 umfasst eine Schutz-Einheit 2 und eine Aufnahme-Einheit 3. Die Schutzeinheit 2 ist rahmenförmig ausgebildet und weist eine zentral angeordnete, rechteckige Schutzöffnung 4 auf. Die Schutzöffnung 4 kann auch andere Grundformen annehmen, insbesondere kann die Schutzöffnung 4 rund, ellipsenförmig, sechseckig oder achteckig sein. Die Schutz-Einheit 2 ist mit der Aufnahme-Einheit 3 einstückig verbunden, wobei die Schutzabdeckung 1 aus einem Material, das eine umformende Herstellung der Schutzabdeckung 1 erlaubt, insbesondere Kunststoff oder Metall, besteht. Weiterhin weist die Schutzabdeckung 1 eine Ablagefläche 5 zur sicheren Ablage der Schutzabdeckung 1 auf einer ebenen Unterlage auf. Die Schutz-Einheit 2 weist eine rechteckige Grundplatte 6 mit zwei gegenüberliegend angeordneten, trapezförmigen Ausnehmungen 7 sowie zwei gegenüberliegend angeordnete Entnahmeöfnungen 8 auf. Die Ausnehmungen 7 und die Entnahmeöffnungen 8 sind jeweils an gegenüberliegenden Kanten 9, 10 der Grundplatte 6 angeordnet. Die Aufnahme-Einheit 3 weist zwei Seitenwände 11 und vier Seitenführungen 12 auf. Die beiden Seitenwände 11 sind an zwei gegenüberliegenden Kanten 10 der Grundplatte 6 derart angeordnet, dass die Seitenwände 11 senkrecht von der Grundplatte 6 hervorstehen. An einem mit der Grundfläche 6 verbundenen Ende gegenüberliegenden Ende der Seitenwand 11 ist ein Rastvorsprung 13 zur rastenden Aufnahme einer flexiblen Leiterplatte 14 vorgesehen, wobei der Rastvorsprung 13 eine Einfuhrschräge 15 und eine Entnahmeschräge 16 zum Einführen und Entnehmen der flexiblen Leiterplatte 14 aufweist. Die Seitenführungen 12 sind senkrecht von der Grundplatte 6 abstehend angeordnet, wobei die Seitenführungen 12 derart an den Außenkanten 9 der Grundplatte 6 angeordnet sind, dass eine seitliche Führung einer aufzunehmenden flexiblen Leiterplatte 14 ermöglicht wird. Von den Seitenführungen 12, den Seitenwänden 11, der Grundplatte 6 und den Rastvorsprüngen 13 wird ein Aufnahme-Raum 17 umgrenzt, der für die Aufnahme der flexiblen Leiterplatte 14 vorgesehen ist. Die beiden Rastvorsprünge 13 begrenzen eine dazwischen liegende Einführöffnung 18. Die flexible Leiterplatte 14 weist eine Aussteifungsplatte 19 und eine Trägerfolie 20 mit einer zu schützenden Oberfläche 21, insbesondere einer Kontaktfläche, auf. Bei einer rastenden Aufnahme der flexiblen Leiterplatte 14 in der Schutzabdeckung 1 ist die Oberfläche 21 an der Schutzöffnung 4 derart angeordnet, dass eine Zugänglichkeit der Oberfläche 21 besteht.

Die in den Figuren 1 bis 3 dargestellte Schutzabdeckung 1 dient der sicheren Aufnahme durch eine rastende Halterung der flexiblen Leiterplatte 14. Dazu wird die flexible Leiterplatte 14 von einer der Ablagefläche 5 gegenüberliegenden Seite der Schutzabdeckung 1 in den Aufnahme-Raum 17 eingeführt. Die flexible Leiterplatte 14 wird mit der Aussteifungsplatte 19 auf den Rastvorsprüngen 13 abgelegt, wobei durch einen Druck auf die Aussteifungsplatte 19 in Richtung des Aufnahme-Raumes 17 die Seitenwände 11 seitlich nach außen gedrückt werden, sodass die Einführöffnung 18 vergrößert wird, bis die flexible Leiterplatte 14 über die Einführschrägen 15 durch die Einführöffnung 18 in den Aufnahme-Raum 17 gelangt. Die flexible Leiterplatte 14 ist während der rastenden Aufnahme in der Schutzabdeckung 1 derart angeordnet, dass die Trägerfolie 20 auf der Grundplatte 6 aufliegt und alle Kanten der Aussteifungsplatte 19 von der Aufnahme-Einheit 3 abschnittsweise umschlossen werden. Die Verbindung der flexiblen Leiterplatte 14 mit der Schutzabdeckung 1 ist lösbar. Zum Lösen der flexiblen Leiterplatte 14 aus der Schutzabdeckung 1 wird die flexible Leiterplatte 14 von der Schutzeinheit 2 weg nach oben aus dem Aufnahme-Raum 17 herausgedrückt. Dazu wird Druck auf die Trägerfolie 20 der flexiblen Leiterplatte 14 ausgeübt, sodass die Rastvorsprünge 13 analog dem Einführvorgang seitlich nach außen gedrückt werden, sodass die flexible Leiterplatte 14 über die Entnahmeschrägen 16 durch die Einführöffnung 18 aus dem Aufnahmeraum 17 entnehmbar ist. Um eine Beschädigung und/oder Verschmutzung der Oberfläche 21 der Trägerfolie 20 während der Entnahme zu vermeiden, wird der Druck auf die Trägerfolie 20 durch die Entnahmeöffnungen 8 oder an den Ausnehmungen 7 aufgebracht.

Eine Schutzabdeckung 1, die lösbar mit einer flexiblen Leiterplatte 14 verbindbar ist, kann am Ende einer Prozesskette von der flexiblen Leiterplatte 14 gelöst und anschließend wieder verwendet werden. Bei einer geeigneten Gestaltung einer Aufnahme-Einheit 3 und einer Schutzeinheit 2kann eine Schutzabdeckung 1 für die Aufnahme mehrerer, verschiedenartiger flexibler Leiterplatten 14 verwendet werden. Es ist weiterhin möglich, die Schutzabdeckung 1 am Ende einer Prozesskette mit der flexiblen Leiterplatte 14 verbunden zu lassen und die Schutzabdeckung 1 bei einer anschließenden Montage der flexiblen Leiterplatte 14 in eine elektronische Baugruppe zu integrieren und insbesondere als Teil eines Gehäuses der elektronischen Baugruppe zu verwenden.

## Patentansprüche

1. Schutzabdeckung (1) zur schützenden Halterung einer flexiblen Leiterplatte (14), mit einer Trägerfolie (20) und einer Aussteifungsplatte (19),umfassend
- eine Schutz-Einheit (2) zur Abdeckung einer Oberfläche (21) der flexiblen Leiterplatte (14) und
- eine Aufnahme-Einheit (3) zur sicheren Aufnahme einer Aussteifungsplatte (19) der flexiblen Leiterplatte (14) mit der Schutzabdeckung (1), wobei die Schutz-Einheit (2) rahmenförmig ausgebildet ist, so dass die zu schützende Oberfläche (21) der flexiblen Leiterplatte (14) zugänglich ist, **dadurch gekennzeichnet, dass**,
- die Aufnahme-Einheit (3) aus mehreren Seitenwänden (11, 12) mit Rastvorsprüngen (13) zur rastenden Aufnahme der Aussteifungsplatte (19) gebildet wird, wobei die Rastvorsprünge (13) Einführschrägen (15) und Entnahmeschrägen (16) zum Einführen und Entnehmen der Aussteifungsplatte (19) aufweisen, und
- die Schutz-Einheit (2) eine rechteckige Grundplatte (6) mit zwei gegenüberliegend angeordneten, trapezförmigen Ausnehmungen (7) sowie zwei gegenüberliegend angeordnete Entnahmeöffnungen (8) aufweist, wobei die Ausnehmungen (7) und die Entnahmeöffnungen (8) geeignet sind, Druck auf die Trägerfolie (20) zum Lösen der flexiblen Leiterplatte (14) aus der Schutzabdeckung (1) derart aufzubringen, dass die flexible Leiterplatte (14) von der Schutzeinheit (2) weg nach oben herausgedrückt werden kann.

2. Schutzabdeckung (1) nach einem der vorgenannten Ansprüche, **dadurch gekennzeichnet, dass** die Aussteifungsplatte (19) lösbar mit der Schutzabdeckung (1) verbunden ist.

3. Schutzabdeckung (1) nach einem der vorgenannten Ansprüche, **dadurch gekennzeichnet, dass** die Aufnahme-Einheit (3) alle Kanten der Aussteifungsplatte (19) abschnittsweise umschließt.

4. Schutzabdeckung (1) nach Anspruch 1, **dadurch gekennzeichnet, dass** die flexible Leiterplatte (14) unlösbar, insbesondere durch eine formschlüssige Steck-Verbindung, verbunden ist.

5. Schutzabdeckung (1) nach einem der vorgenannten Ansprüche, **dadurch gekennzeichnet, dass** die Schutzabdeckung (1) aus Kunststoff besteht.

6. Schutzabdeckung (1) nach einem der vorgenannten Ansprüche, **dadurch gekennzeichnet, dass** die Schutzabdeckung (1) eine Ablagefläche (5) zur sicheren Ablage auf einer ebenen Unterlage aufweist.

7. Schutzabdeckung (1) nach einem der vorgenannten Ansprüche, **dadurch gekennzeichnet, dass** die Schutzabdeckung (1) einstückig hergestellt ist.

8. Leiterplatte (14) mit einer Schutzabdeckung (1) nach einem der vorgenannten Ansprüche, wobei die Leiterplatte (14) von der Schutzabdeckung (1) aufgenommen ist.

## Claims

1. A protective cover (1) for holding a flexible printed circuit board (14) including a carrier film (20) and a reinforcement plate (19) in a manner so as to be protected, comprising
- a protective unit (2) for covering a surface (21) of the flexible printed circuit board (14) and
- a receiving unit (3) for the safe reception of a reinforcement plate (19) of the flexible printed circuit board (14) with the protective cover (1), wherein the protective unit (2) is shaped like a frame, so that the surface (21) of the flexible printed circuit board (14) that is to be protected is accessible, **characterized in that**
- the receiving unit (3) is formed of several side walls (11, 12) provided with snap-fit protrusions (13) for the snap-fit reception of the reinforcement plate (19), wherein the snap-fit protrusions (13) comprise insertion slopes (15) and removal slopes (16) for the insertion and removal of the reinforcement plate (19), and
the protective unit (2) has a rectangular base plate (6) provided with two trapezoidal recesses (7) arranged opposite each other and two removal openings (8) arranged opposite each other, wherein the recesses (7) and the removal openings (8) are suitable for applying pressure to the carrier film (20) for the purpose of releasing the flexible printed circuit board (14) from the protective cover (1) in such a manner that the flexible printed circuit board (14) can be pushed out in an upward direction, away from the protective unit (2).

2. The protective cover (1) according to any one of the preceding claims, **characterized in that** the reinforcement plate (19) is releasably connected to the protective cover (1).

3. The protective cover (1) according to any one of the preceding claims, **characterized in that** the receiving unit (3) encloses sections of all edges of the reinforcement plate (19).

4. The protective cover (1) according to claim1, **characterized in that** the flexible printed circuit board (14) is non-releasably connected, in particular by a positive-fit push-in connection.

5. The protective cover (1) according to any one of the preceding claims, **characterized in that** the protective cover (1) consists of plastic.

6. The protective cover (1) according to any one of the preceding claims, **characterized in that** the protective cover (1) has a placement surface (5) for safe placement on a plane support surface.

7. The protective cover (1) according to any one of the preceding claims, **characterized in that** the protective cover (1) is made of one piece.

8. A printed circuit board (14) provided with a protective cover (1) according to any one of the preceding claims, wherein the printed circuit board (14) is received by the protective cover (1).

## Revendications

1. Recouvrement protecteur (1) pour le support protecteur d'une plaquette à circuit imprimé souple (14), avec une feuille support (20) et une plaque de raidissement (19), comprenant
- une unité de protection (2) pour le recouvrement d'une surface (21) de la plaquette à circuit imprimé souple (14) et
- une unité de réception (3) pour la réception sûre d'une plaque de raidissement (19) de la plaquette à circuit imprimé souple (14) avec le recouvrement protecteur (1), l'unité de protection (2) étant constituée en forme de cadre de telle sorte que la surface à protéger (21) de la plaquette à circuit imprimé souple (14) est accessible, **caractérisé en ce que**
- l'unité de réception (3) est formée de plusieurs parois latérales (11, 12) avec des saillies d'encliquetage (13) pour la réception avec encliquetage de la plaque de raidissement (19), les saillies d'encliquetage (13) présentant des obliquités d'introduction (15) et des obliquités d'extraction (16) pour l'introduction et l'extraction de la plaque de raidissement (19), et
- l'unité de protection (2) présente une plaque de fond (6) avec deux creux (7) trapézoïdaux disposés en opposition ainsi que deux ouvertures d'extraction (8) disposées en opposition, les creux (7) et les ouvertures d'extraction (8) étant appropriés pour appliquer une pression sur la feuille support (20) afin de détacher la plaquette à circuit imprimé souple (14) du recouvrement protecteur (1) de telle sorte que la plaquette à circuit imprimé souple (14) peut être expulsée de l'unité de protection (2) vers le haut.

2. Recouvrement protecteur (1) selon une des revendications précédentes, **caractérisé en ce que** la plaque de raidissement (19) est raccordée de façon détachable au recouvrement protecteur (1).

3. Recouvrement protecteur (1) selon une des revendications précédentes, **caractérisé en ce que** l'unité de réception (3) entoure par tronçons toutes les arêtes de la plaque de raidissement (19).

4. Recouvrement protecteur (1) selon la revendication 1, **caractérisé en ce que** la plaquette à circuit imprimé souple (14) est raccordée de façon non détachable, en particulier par un raccordement par enfichage à liaison de forme.

5. Recouvrement protecteur (1) selon une des revendications précédentes, **caractérisé en ce que** le recouvrement protecteur (1) est réalisé en matière plastique.

6. Recouvrement protecteur (1) selon une des revendications précédentes, **caractérisé en ce que** le recouvrement protecteur (1) présente une surface de pose (5) pour une pose sûre sur une base plane.

7. Recouvrement protecteur (1) selon une des revendications précédentes, **caractérisé en ce que** le recouvrement protecteur (1) est fabriqué d'un seul tenant.

8. Plaquette à circuit imprimé (14) avec un recouvrement protecteur (1) selon une des revendications précédentes, **caractérisé en ce que** la plaquette à circuit imprimé (14) est reçue par le recouvrement protecteur (1).
